(19) Europäisches Patentamt

European Patent Office

Office européen des brevets

(11) **EP 3 167 236 B1**

(12) **EUROPEAN PATENT SPECIFICATION**

(45) Date of publication and mention of the grant of the patent:
**09.03.2022  Bulletin 2022/10**

(21) Application number: **15754005.5**

(22) Date of filing: **09.07.2015**

(51) International Patent Classification (IPC):
**F25B 21/00** *(2006.01)*    **G01J 5/34** *(2022.01)*

(52) Cooperative Patent Classification (CPC):
**F25B 21/00;** F25B 2321/001; Y02B 30/00

(86) International application number:
**PCT/IB2015/055190**

(87) International publication number:
**WO 2016/005932 (14.01.2016 Gazette 2016/02)**

(54) **DEVICE AND PROCESS FOR THE PRODUCTION AND TRANSFER OF HEATING AND COOLING POWER**

VORRICHTUNG UND VERFAHREN ZUR HERSTELLUNG UND ÜBERTRAGUNG VON WÄRME- UND KÄLTEENERGIE

DISPOSITIF ET PROCÉDÉ PERMETTANT LA PRODUCTION ET LE TRANSFERT D'UNE ÉNERGIE DE CHAUFFAGE ET DE REFROIDISSEMENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **10.07.2014  IT MI20141262**

(43) Date of publication of application:
**17.05.2017  Bulletin 2017/20**

(73) Proprietor: **Colognesi, Ernesto**
**23887 Olgiate Molgora (LC) (IT)**

(72) Inventor: **Colognesi, Ernesto**
**23887 Olgiate Molgora (LC) (IT)**

(74) Representative: **Valentini, Giuliano**
**Marietti Gislon e Trupiano S.r.l.**
**Via Larga 16**
**20122 Milano (IT)**

(56) References cited:
**WO-A1-82/00340     WO-A1-2013/167176**
**US-A- 5 644 184     US-A1- 2014 036 449**

**Description**

Field of the invention

The present invention relates a device and process for the production and transfer of heating and cooling power and, in particular, a device and process exploiting properties of electrocaloric dielectric materials in an electrical circuit suitably powered by an electrical power supply source.

Prior Art

Some types of materials show the electrocaloric effect in the form of temperature change of the material when an electric field is applied to the material itself; however, the effect is reversible, that is to say that in the absence of electric field, the material returns to its initial temperature. Generally, materials having this property are dielectric materials and can be used to make capacitors.

Various materials having these properties have long been known and have been studied for several years, although no practical applications have been found. Only in more recent years, new polymers and ceramic materials have been studied, in the form of one or more layers of thin films, thick films or crystals that, having shown high electrocaloric properties, are therefore generating a particular interest for potential practical applications in the industrial field, for example for cooling electronic components or the like.

US Patent n. 6877325 describes, for example, a device for heat transfer that exploits the electrocaloric effect of various types of dielectric materials incorporated into capacitors, having an electric field applied thereto. A "resonant circuitry", alternately charging/discharging a capacitor pair, is generically mentioned. According to this document's teachings, the several described arrangements are able to obtain temperature changes ranging from -10 °C to +50 °C, although no specification is made about the parameters, in particular frequency and duty cycle, of the power supply voltage which generates the electric field at the terminals of the various capacitors.

US Patent n. 8371128 describes some techniques for managing ferromagnetic materials having electrocaloric properties in order to cool down electronic components. The cooling management is controlled by a circuit adjusting the parameters of power supply of the electric field on the layer of electrocaloric material. The controlling circuit is able to adjust several parameters, including the power supply frequency and the duty cycle; in particular embodiments the working frequency can be set to 1 kHz and the duty cycle is set to a value lower than 50%, in particular to 20%.

However, during recent experimental studies it has been found that the electrocaloric effect strongly depends on the frequency of the power supply voltage applied to generate the magnetic field which the electric material is subjected to. For example, this comes to light from the publication "Differential scanning calorimeter and infrared imaging for electrocaloric characterization of poly(vinylidene fluoride-trifluoroethylene-chlorofluoroethylene) terpolymer" (Gael Sebald, Laurence Seveyrat, Jean-Fabien Capsal, Pierre-Jean Cottinet, and Daniel Guyomar - APPLIED PHYSICS LETTERS 101, 022907 - 2012). In fact, in other studies, the terpolymer subjected to tests, known in abbreviated form as P(VDF-TrFE-CFE), has been considered as one of the materials having high elettrocaloric properties, up to estimated $\Delta T$ values of about 12 K (Kelvin) for an applied electric field of a few hundred of V/$\mu$m. From these experimental studies it has been further found that elettrocaloric properties of the terpolymer drastically decrease when the frequency of the power supply voltage of the electric field exceeds the value of 1 Hz. For example, keeping an electric field of 60 V/$\mu$m, as the frequency exceeds the critical value of 1 Hz, $\Delta T$ decreases to values lower than 1 K.

US Patent n. 5644184 describes a device and a method for converting heating power into electric power by exploiting the piezoelectric effect of materials adapted to form the dielectric of a capacitor. Therefore, this document concerns a converting process exactly opposite to that of the present invention, even though it describes some examples of LC resonant circuits in which a pulse, applied to the resonant circuit by means of a transformer where the secondary winding constitutes the inductor of the resonant circuit, is used in order to trigger the oscillation in the resonant circuit thereby starting the conversion from heating power into electric power; by continuously supplying heating power to the piezoelectric material of the capacitor, it is possible to ensure the maintenance of the resonance frequency.

International Patent Application WO 2013/167176 describes another example of conversion from heating power into electric power, i.e. a converting process opposite to that of the present invention. The embodiments described in this document basically provide the coupling of two resonant circuits at slightly different frequencies in order to cause an interference (or beat frequency) that picks up, from pyroelectric material constituting the dielectric of a capacitor, the electrons having increased entropy thereby generating the current to be transferred to a load.

The object of the present invention is to propose a device and process which allow to advantageously exploit the properties of the electrocaloric materials for the production and transfer of heating and cooling power.

It is another object of the present invention to propose a device and process of the above mentioned type which allow to minimize the power required to produce and transfer heating and cooling power by exploiting the properties of electrocaloric materials.

Still another object of the present invention is to provide a device and method which allow to advantageously exploit the properties of electrocaloric materials even with power supply voltages at high frequencies.

A further object of the present invention is to propose a device of the above mentioned type which can be made in many shapes and sizes thereby allowing to implement various types of apparatuses for the production and transfer of heating and cooling power that exploit the electrocaloric effect of materials.

Summary of the invention

These objects are achieved according to the invention by a device according to claim 1 and by a process according to claim 11. Further characteristics and details of the present invention are given in the respective dependent claims.

A device for the production and transfer of heating and cooling power according to an embodiment of the present invention basically comprises a resonant circuit having at least one first inductor connected to at least one first capacitor with a dielectric of electrocaloric material. The resonant circuit further comprises a variable electrical power supply section with a working frequency corresponding to the resonance frequency of the circuit. The electrical power supply section of the resonant circuit advantageously comprises a constant voltage source and at least one pulse source with a predetermined duty cycle for modulating the constant voltage.

A device according to the invention allows to exploit anyway the properties of electrocaloric materials with minimum power consumption even at frequencies definitely higher than those at which the electrocaloric effect is reduced. In fact, the resonant circuit fully exploits the "reactive power" that, in a resonance state, is established between the first inductor and the first capacitor in order to generate the desired electric field on the dielectric of electrocaloric material of the first capacitor, whereas the "active power" is only minimally used to compensate for unavoidable commutation losses and losses in the materials, for example in the dielectric of the capacitors, and the resistivity of the conductors making up the inductors.

In fact, in the traditional art the active power, i.e. the same type of electric power which can activate electric motors, turn on lights or other types of heating or cooling utilities, is believed to be the only one usable, whereas the reactive power would not be usable and would only burden the power-distribution networks and the plants connected thereto.

In other words, unlike conventions of known systems only exploiting the "active power" to generate work, for example if a resistor is used to generate heat by Joule effect, the present invention introduces the exploitation of the only "reactive power" to generate the desired heating or cooling "work", de facto minimizing as much as possible the consumption of "active power".

However, in the perspective of the present invention, it should be appreciated that all the embodiments of the resonant circuits forming the device are free of resistors, i.e. of passive components exploiting the "active power" in order, for example, to obtain the heating through Joule effect. Similarly, there are no diodes which may impede the resonance of the circuit.

In another embodiment of the present invention, at least one second inductor is magnetically coupled to the first inductor and at least one second capacitor with a dielectric of electrocaloric material is connected to the second inductor.

This allows to further exploit the properties of a circuit according to the present invention, by causing the coupling between inductors to transfer energy also to the second capacitor, the latter being connected to the second inductor coupled to the first one, without requiring the addition of further power sources and thereby increasing also the overall gain of the circuit.

Further extending this principle to any desired number of inductor/capacitor pairs, it is therefore possible to provide for an embodiment in which the resonant circuit comprises a plurality of stages connected in parallel to the constant power supply voltage; each stage thus comprises at least one first inductor and at least one first capacitor with a dielectric of electrocaloric material.

In an alternative embodiment, in which the resonant circuit is always made up of any number of stages connected in parallel to the constant power supply voltage, each stage comprises at least one second inductor magnetically coupled to the first inductor; a first capacitor with a dielectric of electrocaloric material is connected to the first inductor and a second capacitor with a dielectric of electrocaloric material is connected to the second inductor.

The dielectric of electrocaloric material can be made up of one or more layers of a thin film, a thick film or crystals of either a terpolymer having these properties, such as for example the already mentioned P(VDF-TrFE-CFE), or a ceramic material such as $BaTiO_3$ able to heat up a solid body, a fluid or a combination thereof.

On the other end, in order to obtain a cooling, the dielectric of electrocaloric material of the capacitors comprises one or more layers of a thin film, a thick film or crystals of a ferroelectric ceramic material, such as for example ceramic materials containing PMN-PT (Lead Magnesium Niobate- Lead Titanate), PZN-PT (Lead Zinc Niobate - Lead Titanate), PST (Lead Scandium Tantalum) or the like.

In order to achieve a high efficiency of a device according to the present invention, the inductors can comprise for example nanocrystalline magnetic cores and the windings can be made of carbon nanotubes.

In order to further improve the performances and reduce commutation losses in a device according to the present invention, the pulse source with a predetermined duty cycle may include, for example, at least one gallium nitride field-effect transistor.

The invention further relates to a process for producing and transferring heating and cooling power, comprising the steps of:

a) providing a resonant electrical circuit having at least one first inductor connected to at least one first capacitor with a dielectric of electrocaloric material; and

b) electrically powering the first capacitor and the first inductor with a variable voltage having a working frequency corresponding to the resonance frequency of the circuit.

In step b), the power supply of the circuit is carried out by powering the resonant circuit with a constant voltage source and modulating the constant voltage with a pulse source having a predetermined duty cycle.

The process according to the invention may also provide the step of magnetically coupling at least one second inductor to the first inductor, for example with a simple air coupling or through a magnetic core. A second capacitor with a dielectric of electrocaloric material is further connected to the second inductor.

The electrocaloric effect can be exploited both for heating up a solid body, a fluid or a combination thereof, and for cooling them down. In case of heating, the dielectric of electrocaloric material of the capacitors comprises for example a thin film, a thick film or crystals of terpolymer whereas, in case of cooling, the dielectric of electrocaloric material of the capacitors comprises, for example, a thin film, a thick film or crystals of ferroelectric ceramic material.

In the process according to the invention, the constant power supply voltage can be modulated with a suitable duty cycle; in fact, it is known that as the duty cycle of a resonant circuit LC decreases gain increases whereby limited values of the duty cycle have to be preferably used, but it is anyway variable depending on the components used to keep a high gain and reduce the inductance values in the resonant circuit. Similarly, still taking into account the optimization criteria of the device based on the employed components, the resonance frequency $f_r$ can also be greater than or equal to 2 kHz.

## Brief description of the drawings

Further characteristics and advantages of the present invention will be more evident from the following description, made for illustration purposes and without limitation, with reference to the attached schematic drawings, wherein:

- Figure 1 is an electric diagram of a possible embodiment of a resonant circuit according to the present invention with a single inductor and a single capacitor;
- Figure 2 is a diagram similar to that one in Figure 1 but with a different connection of the single capacitor;
- Figure 3 is a diagram of another embodiment of the resonant circuit comprising two inductors and two capacitors connected to each others in various ways;
- Figure 4 is a diagram similar to that one in Figure 3 but with a different connection of the components;
- Figure 5 is a diagram similar to that one in Figure 1 but with a pair of inductors connected in parallel to one another;
- Figure 6 is diagram of an embodiment of a resonant circuit according to the present invention, wherein two inductors are magnetically coupled to one another;
- Figure 7 is a diagram similar to that one in Figure 6 but with a different connection of one of the capacitors of the resonant circuit;
- Figure 8 is a diagram similar to that one in Figure 6 with the addition of inductors connected in parallel to the two coupled inductors;
- Figure 9 is a diagram of a resonant circuit according to another embodiment of the present invention, in which there are multiple couplings between inductors;
- Figure 10 is a diagram of a resonant circuit according to another embodiment of the present invention, in which a number of stages are powered in parallel with the power supply voltage;
- Figure 11 is a diagram of a resonant circuit similar to that one in Figure 10, in which a number of stages of coupled inductors is provided;
- Figure 12 is a diagram of a resonant circuit similar to that one in Figure 11, in which each stage comprises coupled inductors and inductors connected in parallel to the coupled components; and
- Figure 13 is an equivalent diagram of a capacitor prototype experimentally implemented and tested.

Modes for carrying out the invention

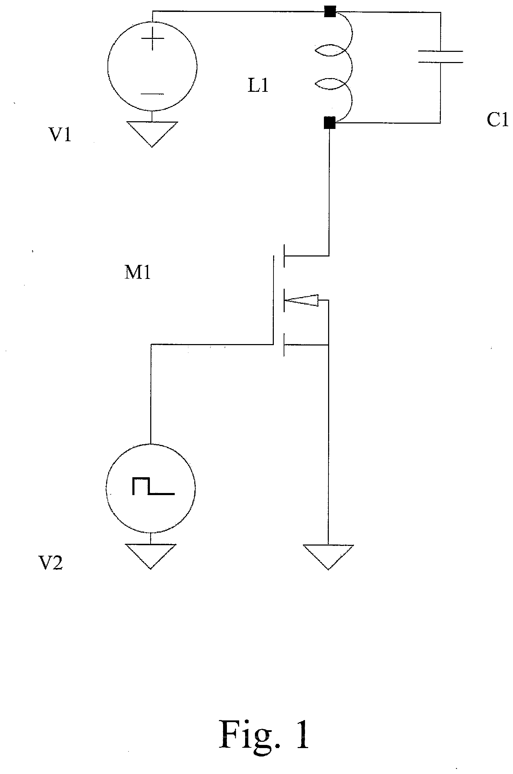

In the simplest embodiment shown in Figure 1, the resonant circuit of a device according to the present invention comprises a first inductor L1 and at least one first capacitor C1 with a dielectric of electrocaloric material, connected in parallel to one another.

As regards the inductors described here and below, the windings have to be preferably made of conductors having low resistivity, such as for example conductors made of carbon nanotubes. Alternatively, windings of conductors made of more common conductive alloys, for example copper-based alloys or the like, can also be used.

The inductors can also be wound on magnetic cores able to increase their inductance leaving unchanged the overall size. Particularly suitable materials for making cores have high permeability, for example nanocrystalline materials of FeCuNbSiB, which allow to make inductors having high inductance values even with a limited number of windings. Alternatively, in the absence of specific limitations to size and/or if no particularly high values of inductance are required, the magnetic cores can also be common ferrite cores.

The components L1 and C1 are powered by a constant voltage source V1 modulated by a pulse source V2, with a predetermined duty cycle, which is applied by means of a semiconductor device M1, preferably a gallium nitride FET in order to limit as much as possible commutation losses, otherwise by means of equivalent devices though having less significant performances, such as for example a MOSFET type transistor IRFH5020 manufactured by International Rectifier (USA). The duty cycle applied to the circuit is preferably reduced in order to have high gain.

Here and below the symbol adopted for the pulse source V2, in which a square or rectangular wave pulse is stylized, is merely indicative; therefore, the pulses provided by the source V2 can take any shape, for example triangular, sinusoidal or the like.

In the embodiment shown herein, by modulating the constant voltage generated by the source V1 it is possible to set the proper resonance frequency $f_r$ in the connection between C1 and L1, defined by the formula:

$$f_r = \frac{1}{2\pi\sqrt{LC}}$$

where L is the inductance of L1 and C is the capacitance of C1.

In order to obtain high outputs, the circuit has to be powered at a frequency preferably higher than 2 kHz. It was observed, in fact, that the electrocaloric effect occurs in any case with significant performances even using frequencies much higher than 1 Hz: taking into account that the work is produced in this way by the only reactive power, the obtained effect is still considerable if compared to the extremely low power consumption of the circuit.

In the electric diagrams described below, the same reference abbreviations of Figure 1 indicate the same components, if not otherwise specified. Similarly, all the additional capacitors which will be described in the following diagrams have to be considered always provided with a dielectric of electrocaloric material.

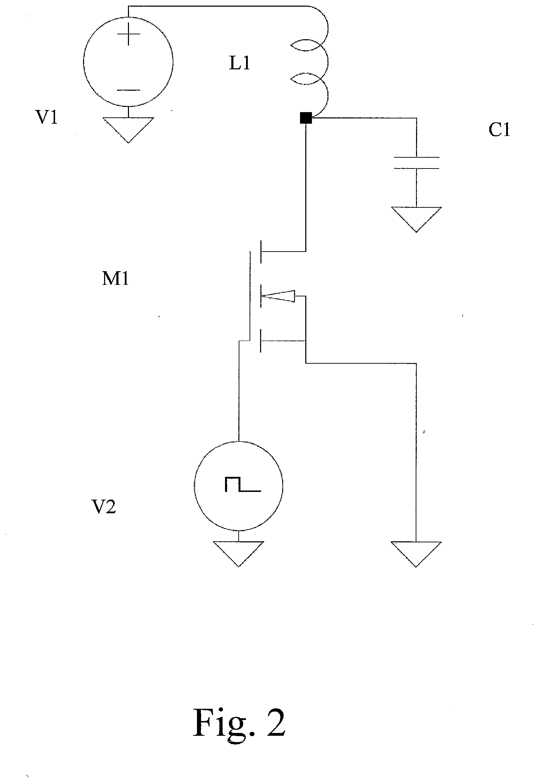

For example, in the diagram of Figure 2 there are all the same components of Figure 1, even though the capacitor C1 is no longer arranged in parallel with the inductor L1 but is instead grounded by one of its terminals.

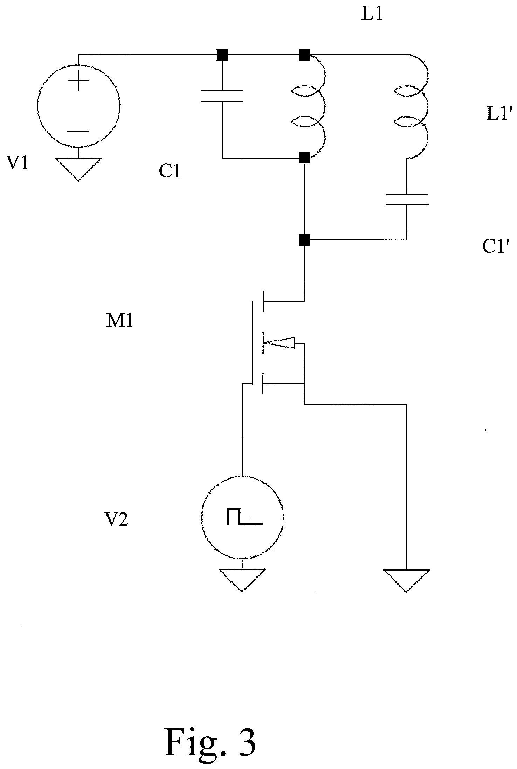

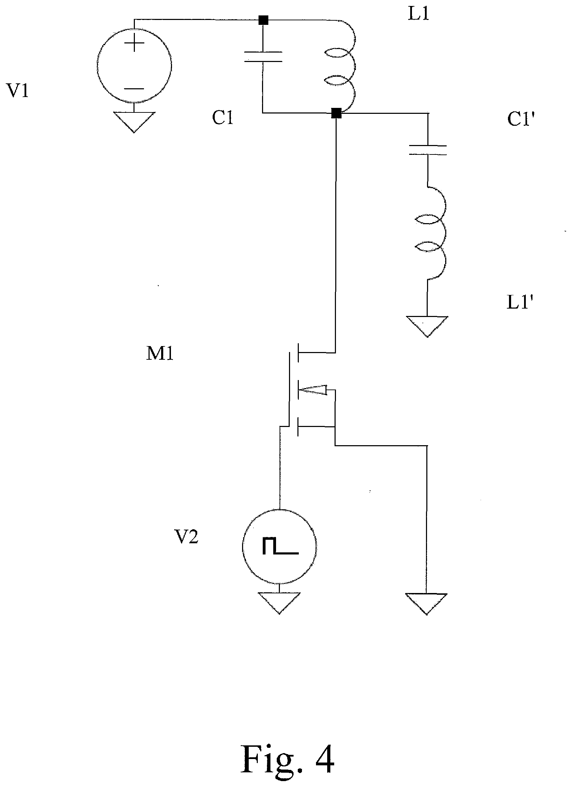

The diagram of Figure 3, in addition to the capacitor C1 and to the inductor L1 connected in parallel to one another, also includes an additional inductor L1' and a further capacitor C1' connected in series to one another; the terminals of the series connection of C1' and L1' are in turn connected in parallel to components L and C. In Figure 4 a similar circuit is shown but where the series connection of the capacitor C1' and the inductor L1' has differently a terminal connected to ground (or negative pole) rather than connected to the positive pole of the constant voltage source VI.

In both the embodiments of Figures 3 and 4, the capacitance value of the capacitor C1 can be equal to that of the capacitor C1' so that the electrocaloric effect is substantially evenly distributed on both of them, whereas the inductance values of the inductors L1 and L1' can also be different from each other, depending on the desired resonance frequency at which the circuit should operate.

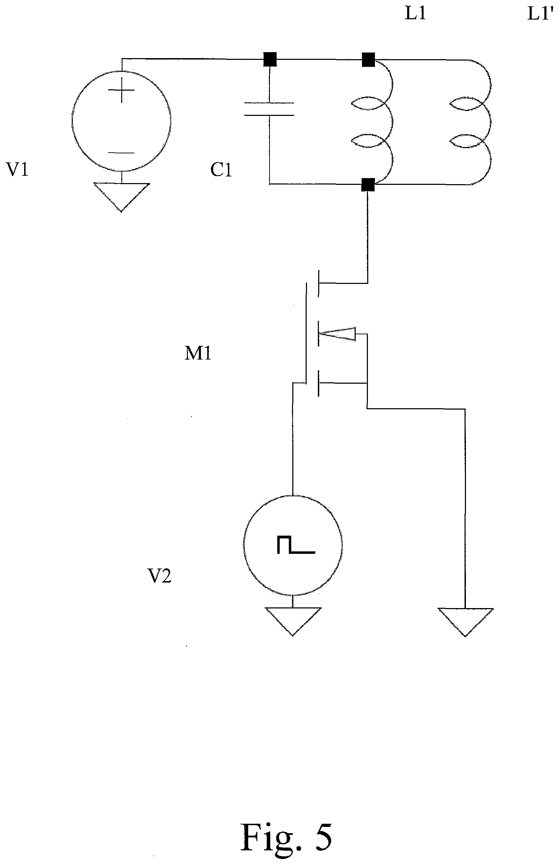

In the diagram of Figure 5 a circuit similar to that one of Figure 1 is shown, in which there are two inductors L1 and L1' connected in parallel and preferably having the same inductance. This allows the distribution of any excessive current load in the oscillating circuit. As evident to a skilled in the art, there can also be more than two inductors connected in parallel and the two or more inductors can have windings made without any magnetic core, or else wound on the same magnetic core or on distinct magnetic cores.

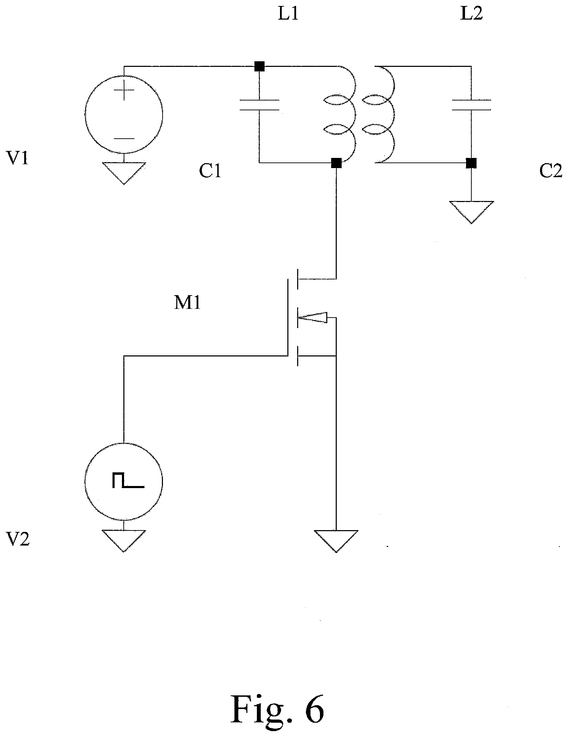

Instead, in the embodiment of Figure 6 two inductors L1 and L2 magnetically coupled to each other are provided. The first capacitor C1 is connected in parallel to the first inductor L1, as already shown for example in Figure 1, whereas a second capacitor C2 is connected in parallel to the second inductor L2. Due to the magnetic coupling between the two inductors L1 and L2, also the two components C2 and L2 connected to each other are subjected to the same working frequency applied to the components C1 and L1 and may share the same values of capacitance and inductance therewith.

The inductors can be magnetically coupled through air or through a magnetic core. In this case, the magnetic core for coupling the inductors L1 and L2 shown in Figure 6 is also preferably made of materials having high permeability, such as nanocrystalline materials of FeCuNbSiB. Similarly to the individual inductors described hitherto, the coupling magnetic cores can also take the form of common ferrite cores, such as those available on the market with the abbreviation ETD (Economical Transformer Design). This also applies to all the coupled inductors of the circuits described below.

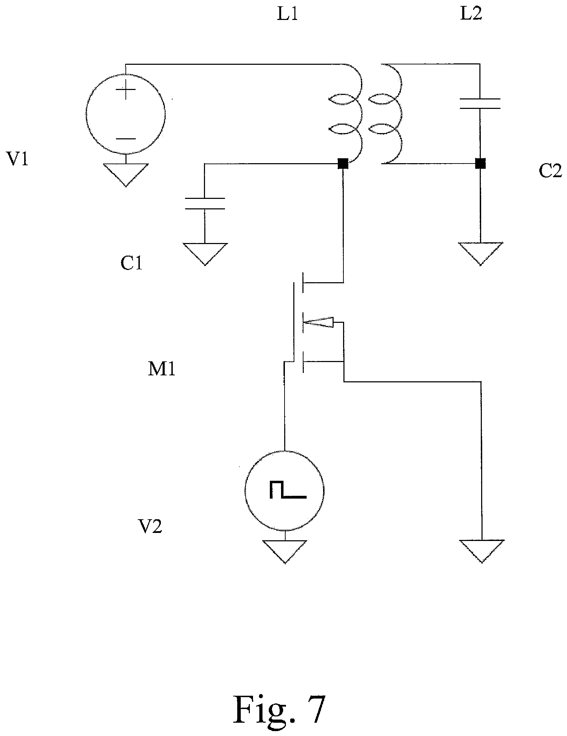

As regards the magnetic coupling between the inductors shown in Figure 6, as well as for the coupling of those described below, the ratio of coupling, or of transformation, can be 1:1, that is to say with coupled inductors having the same inductance value, or else with different ratios, either with a "step-up" transformation ratio or with a "step-down" transformation ratio, whereby the inductors will have inductance values different from each other. The capacitance values of the capacitors connected to the coupled inductors will in turn be selected to comply with the resonant frequency set in the circuit. The circuit of Figure 7 is similar to that of Figure 6, the only difference between them being that one of the terminals of the capacitor C1 is connected to ground rather than to the positive pole of the generator V1.

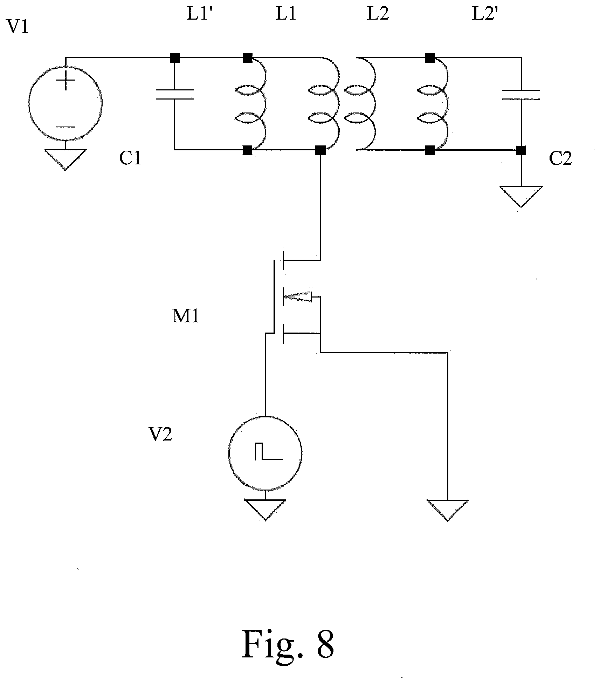

The circuit of Figure 8 is another variation of the circuit of Figure 6, with further inductors L1' and L2' connected in parallel respectively to the coupled inductors L1 and L2 in the case where high currents are caused in the resonant circuit. All the inductors preferably have the same inductance value, although variations to this solution can also be provided in particular cases. The additional inductors connected in parallel to the coupled inductors may also be more than those shown.

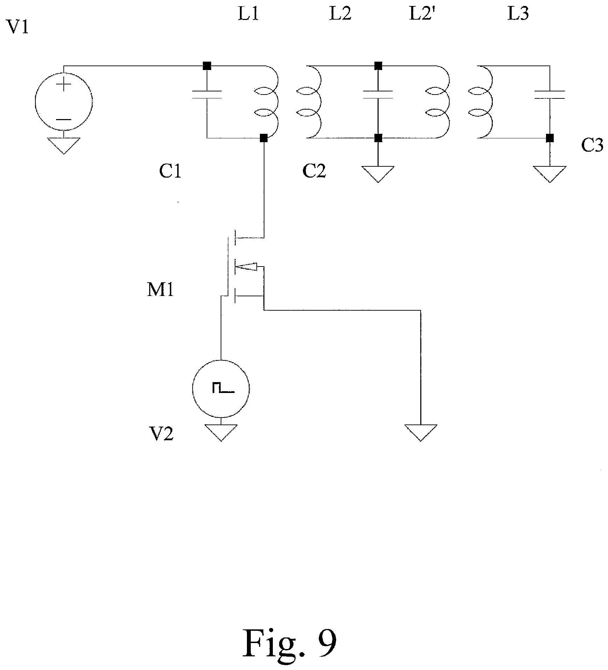

Figure 9 shows another diagram of a resonant circuit according to the invention, in which groups of cascade-coupled inductors are provided. In particular, in addition to the coupled inductors L1 and L2, which are connected to respective capacitors C1 and C2, a further inductor L2' is connected in parallel to the inductor L2 and is in turn coupled to a further inductor L3 connected to a respective capacitor C3. Also in this case, more groups of components can follow the principle of cascade-coupling the inductors to each other. The values of inductance and capacitance of the various components in each group are determined so as to keep the resonance of all the groups at the same frequency.

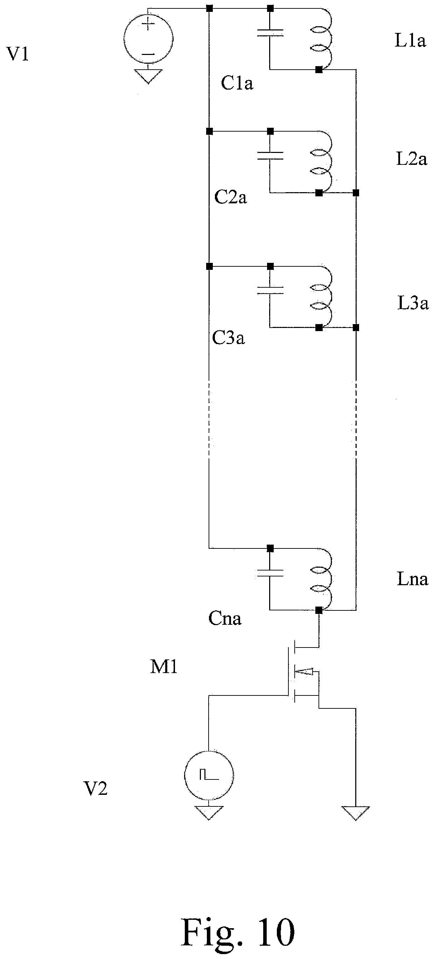

In the circuit of Figure 10 a number of stages of inductors and capacitors connected to each other are used; all stages are in turn connected in parallel to the same source V1 of DC voltage modulated by the same pulse source V2. In practice, the same power supply is applied simultaneously to the stages Cla-Lla, L2a-C2a, C3a-L3a up to the n-th stage Cna-Lna. For example, the number "n" of inductor/capacitor stages can depend on the heating power required for the particular application and/or on the size of the body or fluid to be heated/cooled. In this embodiment, all the inductors preferably have an identical inductance value but, in particular cases, variations to this solution can also be provided; the capacitors will therefore have an identical capacitance value, or a value calculated to comply with the resonance frequency set in the circuit.

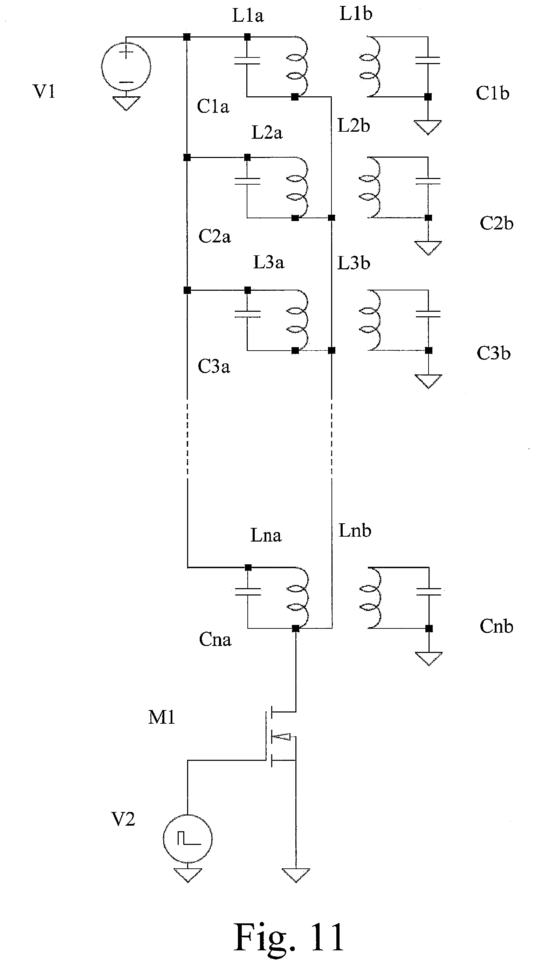

The same principles of the circuit of Figure 10 can also be found in the circuit of Figure 11, in which a plurality of "n" stages comprising a second inductor L1b, L2b, L3b... Lnb are provided, respectively coupled to each first inductor L1a, L2a, L3a... Lna. Each inductor L1a, L2a, L3a... Lna is connected in parallel to a respective capacitor C1a, C2a, C3a... Cna, as well as each inductor L1b, L2b, L3b... Lnb is connected in parallel to a respective capacitor C1b, C2b, C3b... Cnb. Also in this embodiment, all the inductors may have an identical inductance value or, in particular cases, may also be different from each other, therefore taking into account that the capacitors will have a capacitance value suitable to comply with the resonance frequency set in the circuit.

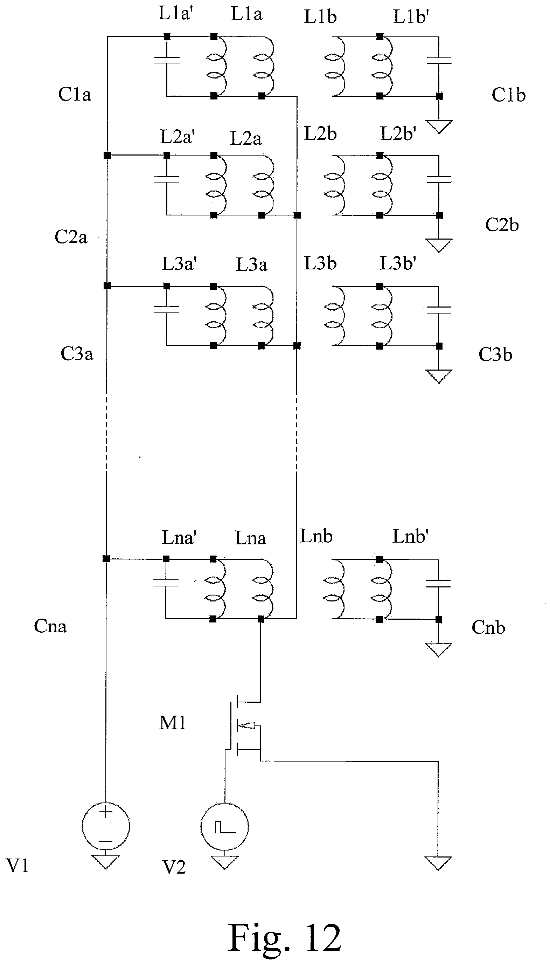

The diagram of Figure 12 is a combination of the various embodiments already illustrated herein, in which a plurality of stages are connected in parallel to the same sources V1 and V2. In practice, the first stage in the upper part of the diagram includes coupled inductors L1a and L1b which are connected in parallel to respective inductors L1a' and L1b' and respective capacitors C1a and C1b; in the second stage, the coupled inductors L2a and L2b are connected in parallel to respective inductors L2a' and L2b' and respective capacitors C2a and C2b; in the third stage, the coupled inductors L3a and L3b are connected in parallel to respective inductors L3a" and L3b' and respective capacitors C3a and C3b, and so on up to the n-th stage, in which the coupled inductors Lna and Lnb are connected in parallel to respective inductors Lna' and Lnb' and respective capacitors Cna and Cnb. In this embodiment, as well as in those described hitherto, the inductance and capacitance values of inductors and capacitors will be determined so as to comply with the resonant frequency set in the circuit.

The elettrocaloric material to be used as a dielectric for capacitors is selected based on the various heating or cooling applications to be implemented. In case of heating, a suitable material may be for example a terpolymer, whereas in case of cooling it is possible to use a ferroelectric ceramic material, for example.

These materials may be used in the form of thin films, thick films or crystals to make flat capacitors that can be applied to a heat exchanger, for example a heat-exchange apparatus of the "waterblock" type or the like, i.e. a solid block in which a heat-exchange fluid is made to flow. Flat capacitors may be applied to the surface of the solid body of the exchanger, possibly by interposing a film of electrically insulating material having, however, high heat transfer properties, for example that one with the trade name KAPTON® available by DuPont.

However, in manufacturing a heating apparatus, limitations of electrocaloric materials known hitherto should be considered. For example, the aforementioned terpolymer P(VDF-TrFE-CFE) has a melting temperature of about 80°C. Therefore, in order to prevent the capacitor dielectric from being damaged, it should be used at lower temperatures, for example not exceeding temperatures of 50 °C. If it is necessary to achieve a greater thermal drop $\Delta T$, it is however possible to put in series several heat exchangers having heating elements (capacitors) of the same type.

If an instantaneous water heater has to be implemented, assuming a target thermal drop $\Delta T$ of 25 °C, the desired temperature can be achieved by several heat exchangers in series and, based on the water flow rate to be heated, an automatic control can be carried out by acting on the power supply voltage and/or by enabling or excluding individual heating elements.

For heating houses or, in general, buildings, because very high temperatures have to be achieved it is possible to use, for example, a boiler with thermal stratification. Assuming that the maximum temperature achievable by the hot water is 50°C, to protect the heating elements, an apparatus of this type may increase the temperature up to more than 75°C.

In case of cooling, being carried out as already mentioned by implementing capacitors with dielectrics constituted by thin films, thick films or crystals of ferroelectric ceramic materials, the same solutions can be used.

Hereinbelow are some examples to determine the actual possibility of exploiting an electrocaloric material, in particular a terpolymer, able to heat up although subjected to a high frequency electric field.

Example 1: Implementation of a prototype of heating element

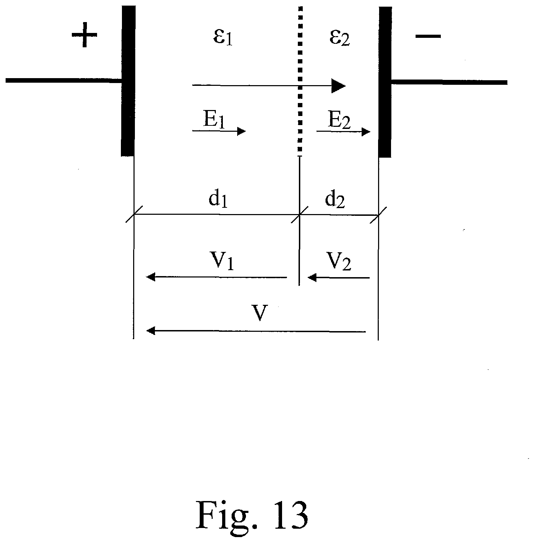

A prototype of flat capacitor having the dielectric made up of two layers close to each other and adhering to the plates has been implemented. The first dielectric was a terpolymer PVDF-TrFE-CTFE (elettrocaloric material), whereas the second layer was constituted by air. Thus, the equivalent diagram is that of two capacitors connected in series, as depicted in Figure 13.

The characteristics of the dielectric terpolymer were as follows:

$$\text{Side} = 0.03 \text{ x } 0.03 \text{ m}$$

Surface $S = 0.0009 \text{ m}^2$
Thickness of the PVDF-TrFE-CTFE film= 10 $\mu$m

Taking into account the dielectric constant in the vacuum ($\varepsilon_0 = 8.854*10^{-12}$ F/m), the values of the capacitances C1 (terpolymer) and C2 (air) were calculated.

The value of C1 was calculated as follows:
Relative permittivity of the terpolymer $\varepsilon_r 1 = 37$

$$\varepsilon 1 = 327.6*10^{-12} \text{ F/m} = \varepsilon_r 1 \text{ x } \varepsilon_0$$

$$C1 = 29.480*10^{-12} \text{ F } (\varepsilon 1 * \text{Surface/Thickness})$$

The value of C2 was in turn calculated as follows:

Air thickness = 4.23 $\mu$m
Relative permittivity of air $\varepsilon_r 2 = 1$

$$\varepsilon 2 = 8.854*10^{-12} \text{ F/m} = \varepsilon_r 2 \text{ x } \varepsilon_0$$

$$C2 = 1883.8*10^{-12} \text{ F } (\varepsilon 2 * \text{Surface/Thickness})$$

The series connection of the two capacitors corresponds to a total capacitance calculated according to the formula:

$$Ctotale = \frac{1}{\frac{1}{C1} + \frac{1}{C2}} = 1773*10^{-12} \text{ F } = 1{,}773 \, nF$$

Example 2: Experimental tests

The capacitor made according to the example has been connected in parallel to an inductor, as in the circuit of Figure 1.

A sinusoidal voltage with a working frequency of 87,600 Hz (87.6 kHz) and effective value of the voltage of 200 $V_{rms}$ was selected to be set in the circuit.

Once the total capacitance of the capacitor is known, the inductance value that satisfies the relation with the working frequency of 87.6 kHz was calculated to be 1.86 mH.

The heat generated by the PVDF-TrFE-CTFE film was compared with the heat generated by an electrical resistance of 220 $\Omega$ powered at 22.69 volts and a current absorption of 0.103136 A.

As the temperature of the two systems reached 50 °C, it was possible to calculate the thermal power generated by the elettrocaloric film by detecting the electric power consumed by the resistor, equal to 2.34 W.

The power shares absorbed by each part of the capacitor prototype of Example 1 were calculated by taking into account the overall reactance $X_C$ and single reactances $X_{C1}$ and $X_{C2}$ according to the known formula:

$$Xc = \frac{1}{2\pi f C}$$

from which it follows:

Ctotal = 1773 pF Xc = 1025.3 $\Omega$ Vrms = 200 A = 0.195 Watt = 39;
C1 = 29480 pF Xc1 = 61.66 $\Omega$ Vrms = 12 A =0.195 Watt = 2.34;
C2 = 1883.8 pF Xc2 = 964.6 $\Omega$ Vrms = 188 A =0.195 Watt =36.66.

Knowing the total voltage, the partial voltage applied to the electrocaloric film and the partial voltage applied to the air were calculated. Therefore it was possible to calculate the actual power absorbed by the electrocaloric film, since air absorbs power without returning heating power.

Various modifications may be made to the embodiments described herein without departing from the scope of the present invention. For example, instead of the components schematically shown with V2 and M1, a suitably programmed oscillator can be adopted as long as it is able to provide the required characteristics of frequency and duty cycle. Furthermore, other suitable materials having the electrocaloric effect can be used in addition to those explicitly mentioned in the description.

**Claims**

1. A device for the production and transfer of heating and cooling power, comprising at least one first capacitor (C1) with a dielectric of electrocaloric material and an electrical resonant circuit having at least one first inductor (L1) connected to said at least one first capacitor (C1), wherein said resonant circuit comprises a variable electrical power supply section to power said resonant circuit with a working frequency corresponding to the resonance frequency of the circuit, wherein the electrical power supply section to power said resonant circuit comprises a constant voltage source (V1) and at least one pulse source (V2) with a predetermined duty cycle for modulating said constant voltage (V1).

2. The device according to claim 1, wherein said resonant circuit is free of resistors and diodes.

3. The device according to claim 1, wherein at least one second inductor (L2) is magnetically coupled to said at least one first inductor (L1), and wherein at least one second capacitor (C2) with a dielectric of electrocaloric material is connected to said at least one second inductor (L2).

4. The device according to claim 1, wherein said resonant circuit comprises a plurality of stages connected in parallel to said constant power supply voltage (VI), and wherein each of said stages comprises at least one first inductor (L1a-Lna) and at least one first capacitor (C1a-Cna) with a dielectric of electrocaloric material.

5. The device according to claim 1, wherein said resonant circuit comprises a plurality of stages connected in parallel to said constant power supply voltage, wherein each of said stages comprises at least one second inductor (L1b-Lnb) magnetically coupled to said at least one first inductor (L1a-Lna), and wherein at least one first capacitor (C1a-Cna) with a dielectric of electrocaloric material is connected to said at least one first inductor (L1a-Lna), and a second capacitor (C1b-Cnb) with a dielectric of electrocaloric material is connected to said at least one second inductor (L1b-Lnb).

6. The device according to claims 1 to 5, wherein the dielectric of electrocaloric material of said capacitors (C1, C1', C2, C2', C3, C1a-Cna, C1b-Cnb, C1a'-Cna', C1b'-Cnb') comprises one or more layers of a thin film, a thick film or crystals of either a terpolymer or a ferroelectric ceramic material able to heat up when it is subjected to an electric field.

7. The device according to claims 1 to 5, wherein the dielectric of electrocaloric material of said capacitors (C1, C1', C2, C2', C3, C1a-Cna, C1b-Cnb, C1a'-Cna', C1b'-Cnb') comprises one or more layers of a thin film, a thick film or crystals of a ferroelectric ceramic material able to cool down when it is subjected to an electric field.

8. The device according to claims 1 to 5, wherein said inductors (L1, L1', L2, L2', L3, L1a-Lna, Llb-Lnb, L1a'-Lna', L1b'-Lnb') comprise nanocrystalline magnetic cores.

9. The device according to claims 1 to 5, wherein said inductors (L1, L1', L2, L2', L3, L1a-Lna, Llb-Lnb, L1a'-Lna', L1b'-Lnb') comprise windings of conductors made of carbon nanotubes.

10. The device according to claim 1, wherein said pulse source (V2) with a predetermined duty cycle comprises at least one gallium nitride field-effect transistor (M1).

11. A process for producing and transferring heating and cooling power, comprising the steps of:

> a) providing a resonant electrical circuit having at least one first inductor (L1) connected to at least one first capacitor (C1) with a dielectric of electrocaloric material; and
> b) electrically powering said at least one first capacitor (C1) and said at least one first inductor (L1) with a variable voltage having a working frequency equal to the resonance frequency of the circuit, by powering the resonant circuit with a constant voltage source (V1) and modulating said constant voltage (V1) with a pulse source (V2) having a predetermined duty cycle.

12. The process according to claim 11, wherein a step is provided which comprises magnetically coupling at least one second inductor (L2) to said at least one first inductor (L1), and wherein at least one second capacitor (C2) with a dielectric of electrocaloric material is connected to said at least one second inductor (L2).

13. The process according to claims 11 to 12, wherein the production and transfer of heating power comprise heating a solid body, a fluid or a combination thereof, and wherein the dielectric of electrocaloric material of said capacitors (C1, C1', C2, C2', C3, C1a-Cna, C1b-Cnb, C1a'-Cna', C1b'-Cnb') comprises one or more layers of a thin film, a thick film or crystals of either a terpolymer or a ferroelectric ceramic material.

14. The process according to claims 11 to 12, wherein the production and transfer of cooling power comprise cooling a solid body, a fluid or a combination thereof, and wherein the dielectric of electrocaloric material of said capacitors (C1, C1', C2, C2', C3, C1a-Cna, C1b-Cnb, C1a'-Cna', C1b'-Cnb') comprises one or more layers of a thin film, a thick film or crystals of a ferroelectric ceramic material.

15. The process according to claim 11, wherein said resonance frequency $f_r$ is greater than or equal to 2 kHz.

16. A heating or cooling apparatus comprising a device for the production and transfer of heating and cooling power according to any one of claims 1-10.

**Patentansprüche**

1. Vorrichtung zur Erzeugung und Übertragung von Heiz- und Kühlleistung, aufweisend mindestens einen ersten Kondensator (C1) mit einem Dielektrikum aus elektrokalorischem Material und einem elektrischen Schwingkreises mit mindestens einem ersten Induktor (L1), der mit dem mindestens einen ersten Kondensator (C1) verbunden ist, wobei der Schwingkreis einen variablen Stromversorgungsabschnitt aufweist, um den Schwingkreis mit einer Arbeitsfrequenz zu versorgen, die der Schwingungsfrequenz des Schwingkreises entspricht, wobei der Stromversorgungsabschnitt zur Versorgung des Schwingkreises eine Konstantspannungsquelle (V1) und mindestens eine Impulsquelle (V2) mit einem vordefinierten Arbeitszyklus zum Modulieren der Konstantspannung (V1) aufweist.

2. Vorrichtung nach Anspruch 1, wobei der Schwingkreis frei von Widerständen und Dioden ist.

3. Vorrichtung nach Anspruch 1, wobei der mindestens eine zweite Induktor (L2) mit dem mindestens einen ersten Induktor (L1) magnetisch gekoppelt ist und wobei mindestens ein zweiter Kondensator (C2) mit einem Dielektrikum aus elektrokalorischem Material mit dem mindestens einen zweiten Induktor (L2) verbunden ist.

4. Vorrichtung nach Anspruch 1, wobei der Schwingkreis eine Vielzahl von Stufen aufweist, die parallel mit der Konstantspannungsquelle (V1) verbunden sind und wobei jede der Stufen mindestens einen ersten Induktor (L1a-Lna) und mindestens einen ersten Kondensator (C1a-Cna) mit einem Dielektrikum aus elektrokalorischem Material aufweist.

5. Vorrichtung nach Anspruch 1, wobei der Schwingkreis eine Vielzahl von Stufen aufweist, die parallel mit der Konstantspannungsquelle verbunden sind und wobei jede der Stufen mindestens einen mit dem mindestens einen ersten Induktor (L1a-Lna) magnetisch gekoppelten zweiten Induktor (L1b-Lnb) aufweist und wobei mindestens ein erster Kondensator (C1a-Cna) mit einem Dielektrikum aus elektrokalorischem Material mit dem mindestens einen ersten Induktor (L1a-Lna) verbunden ist und wobei ein zweiter Kondensator (C1b-Cnb) mit einem Dielektrikum aus elektrokalorischem Material mit dem mindestens einen zweiten Induktor (L1b-Lnb) verbunden ist.

6. Vorrichtung nach einem der Ansprüche 1 bis 5, wobei das Dielektrikum aus elektrokalorischem Material der Kondensatoren (C1, C1', C2, C2', C3, C1a-Cna, C1b-Cnb, C1a'-Cna', C1b'-Cnb') eine oder mehrere Schichten aus einem Dünnfilm, einem Dickfilm oder aus Kristallen entweder eines Terpolymers oder eines ferroelektrischen Keramikmaterials aufweist, welches sich erwärmen kann, wenn es einem elektrischen Feld ausgesetzt wird.

7. Vorrichtung nach einem der Ansprüche 1 bis 5, wobei das Dielektrikum aus elektrokalorischem Material der Kondensatoren (C1, C1', C2, C2', C3, C1a-Cna, C1b-Cnb, C1a'-Cna', C1b'-Cnb') eine oder mehrere Schichten aus einem Dünnfilm, einem Dickfilm oder aus Kristallen eines ferroelektrischen Keramikmaterials aufweist, welches sich abkühlen kann, wenn es einem elektrischen Feld ausgesetzt wird.

8. Vorrichtung nach einem der Ansprüche 1 bis 5, wobei die Induktoren (L1, L1', L2, L2', L3, L1a-Lna, L1b-Lnb, L1a'-Lna', L1b'-Lnb') nanokristalline Magnetkerne aufweisen.

9. Vorrichtung nach einem der Ansprüche 1 bis 5, wobei die Induktoren (L1, L1', L2, L2', L3, L1a-Lna, L1b-Lnb, L1a'-Lna', L1b'-Lnb') Wicklungen von aus Kohlenstoff-Nanoröhren hergestellten Kondensatoren aufweisen.

10. Vorrichtung nach Anspruch 1, wobei die Impulsquelle (V2) mit einem vordefinierten Arbeitszyklus mindestens einen feldeffektiven Galiumnitrid-Transistor (M1) aufweist.

11. Ein Verfahren zur Erzeugung und Übertragung von Heiz- und Kühlleistung, aufweisend die folgenden Schritte:

a) Bereitstellen eines elektrischen Schwingkreises mit einem ersten Induktor (L1), der mit einem ersten Kondensator (C1) mit einem Dielektrikum aus elektrokalorischem Material verbunden ist, und
b) elektrisches Versorgen des mindestens einen ersten Kondensators (C1) und des mindestens einen ersten Induktors (L1) mit einer variablen Spannung mit einer Arbeitsfrequenz gleich der Schwingungsfrequenz des Schwingkreises,

durch Versorgen des Schwingkreises mit einer Konstantspannungsquelle (V1) und Modulieren der Konstantspannung (V1) mit einer Impulsquelle (V2) mit einem vordefinierten Arbeitszyklus.

12. Verfahren nach Anspruch 11, wobei ein Schritt vorgesehen ist, der die magnetische Koppelung mindestens eines zweiten Induktors (L2) mit dem mindestens einen ersten Induktor (L1) aufweist, und wobei der mindestens eine zweite Kondensator (C2) mit einem Dielektrikum aus elektrokalorischem Material mit dem mindestens einen zweiten Induktor (L2) verbunden ist.

13. Verfahren nach einem der Ansprüche 11 bis 12, wobei die Erzeugung und Übertragung der Heizkraft das Erwärmen eines Festkörpers, eines Fluids oder einer Kombination davon umfasst und wobei das Dielektrikum aus elektrokalorischem Material der Kondensatoren (C1, C1', C2, C2', C3, C1a-Cna, C1b-Cnb, C1a'-Cna', C1b'-Cnb') eine oder mehrere Schichten aus einem Dünnfilm, einem Dickfilm oder aus Kristallen entweder eines Terpolymers oder eines ferroelektrischen Keramikmaterials aufweist.

14. Verfahren nach einem der Ansprüche 11 bis 12, wobei die Erzeugung und Übertragung der Kühlkraft das Abkühlen eines Festkörpers, eines Fluids oder einer Kombination davon umfasst und wobei das Dielektrikum aus elektrokalorischem Material der Kondensatoren (C1, C1', C2, C2', C3, C1a-Cna, C1b-Cnb, C1a'-Cna', C1b'-Cnb') eine oder mehrere Schichten aus einem Dünnfilm, einem Dickfilm oder aus Kristallen eines ferroelektrischen Keramikmaterials aufweist.

15. Verfahren nach Anspruch 11, wobei die Resonanzfrequenz $f_r$ größer oder gleich 2 kHz ist.

16. Heiz- oder Kühlvorrichtung, umfassend eine Vorrichtung zur Erzeugung oder Übertragung von Heiz- und Kühlleistung nach einem der Ansprüche 1 bis 10.

**Revendications**

1. Dispositif pour la production et le transfert d'une énergie de chauffage et de refroidissement, comprenant au moins un premier condensateur (C1) avec un diélectrique de matériau électrocalorique et un circuit résonant électrique ayant au moins une première bobine d'induction (L1) connectée audit au moins un premier condensateur (C1), dans lequel ledit circuit résonant comprend une section d'alimentation en énergie électrique variable pour alimenter en énergie ledit circuit résonant avec une fréquence de travail correspondant à la fréquence de résonance du circuit, dans lequel la section d'alimentation en énergie électrique pour alimenter en énergie ledit circuit résonant comprend une source de tension constante (V1) et au moins une source d'impulsions (V2) avec un rapport cyclique prédéterminé pour moduler ladite tension constante (V1).

2. Dispositif selon la revendication 1, dans lequel ledit circuit résonant est exempt de résistances et de diodes.

3. Dispositif selon la revendication 1, dans lequel au moins une seconde bobine d'induction (L2) est couplée magnétiquement à ladite au moins une première bobine d'induction (L1), et dans lequel au moins un second condensateur (C2) avec un diélectrique de matériau électrocalorique est connecté à ladite au moins une seconde bobine d'induction (L2).

4. Dispositif selon la revendication 1, dans lequel ledit circuit résonant comprend une pluralité d'étages connectés en parallèle à ladite tension d'alimentation en énergie constante (V1), et dans lequel chacun desdits étages comprend au moins une première bobine d'induction (L1a-Lna) et au moins un premier condensateur (C1a-Cna) avec un diélectrique de matériau électrocalorique.

5. Dispositif selon la revendication 1, dans lequel ledit circuit résonant comprend une pluralité d'étages connectés en parallèle à ladite tension d'alimentation en énergie constante, dans lequel chacun desdits étages comprend au moins une seconde bobine d'induction (L1b-Lnb) couplée magnétiquement à ladite au moins une première bobine d'induction (L1a-Lna), et dans lequel au moins un premier condensateur (C1a-Cna) avec un diélectrique de matériau électrocalorique est connecté à ladite au moins une première bobine d'induction (L1a-Lna), et un second condensateur (C1b-Cnb) avec un diélectrique de matériau électrocalorique est connecté à ladite au moins une seconde bobine d'induction (L1b-Lnb).

6. Dispositif selon les revendications 1 à 5, dans lequel le diélectrique de matériau électrocalorique desdits condensateurs (C1, C1', C2, C2', C3, C1a-Cna, C1b-Cnb, C1a'-Cna', C1b'-Cnb') comprend une ou plusieurs couches d'un film mince, d'un film épais ou de cristaux d'un terpolymère ou d'un matériau céramique ferroélectrique capable de s'échauffer lorsqu'il est soumis à un champ électrique.

7. Dispositif selon les revendications 1 à 5, dans lequel le diélectrique de matériau électrocalorique desdits condensateurs (C1, C1', C2, C2', C3, C1a-Cna, C1b-Cnb, C1a'-Cna', C1b'-Cnb') comprend une ou plusieurs couches d'un film mince, d'un film épais ou de cristaux d'un matériau céramique ferroélectrique capable de se refroidir lorsqu'il est soumis à un champ électrique.

8. Dispositif selon les revendications 1 à 5, dans lequel lesdites bobines d'induction (L1, L1', L2, L2', L3, L1a-Lna, L1b-Lnb, L1a'-Lna', L1b'-Lnb') comprennent des noyaux magnétiques nanocristallins.

9. Dispositif selon les revendications 1 à 5, dans lequel lesdites bobines d'induction (L1, L1', L2, L2', L3, L1a-Lna, L1b-Lnb, L1a'-Lna', L1b'-Lnb') comprennent des enroulements de conducteurs en nanotubes de carbone.

10. Dispositif selon la revendication 1, dans lequel ladite source d'impulsions (V2) à rapport cyclique prédéterminé comprend au moins un transistor à effet de champ en nitrure de gallium (M1).

11. Procédé de production et de transfert d'une énergie de chauffage et de refroidissement, comprenant les étapes consistant à :

    a) fournir un circuit électrique résonant ayant au moins une première bobine d'induction (L1) connectée à au moins un premier condensateur (C1) avec un diélectrique de matériau électrocalorique ;
et
b) alimenter électriquement en énergie ledit au moins un premier condensateur (C1) et ladite au moins une première bobine d'induction (L1) avec une tension variable ayant une fréquence de travail égale à la fréquence de résonance du circuit, en alimentant en énergie le circuit résonant avec une source de tension constante (V1) et en modulant ladite tension constante (V1) avec une source d'impulsions (V2) ayant un rapport cyclique prédéterminé.

12. Procédé selon la revendication 11, dans lequel une étape est prévue qui comprend le couplage magnétique d'au moins une seconde bobine d'induction (L2) à ladite au moins une première bobine d'induction (L1), et dans lequel au moins un second condensateur (C2) avec un diélectrique de matériau électrocalorique est connecté à ladite au moins une seconde bobine d'induction (L2).

13. Procédé selon les revendications 11 à 12, dans lequel la production et le transfert d'une énergie de chauffage comprennent le chauffage d'un corps solide, d'un fluide ou d'une combinaison de ceux-ci, et dans lequel le diélectrique de matériau électrocalorique desdits condensateurs (C1, C1', C2, C2', C3, C1a-Cna, C1b-Cnb, C1a'-Cna', C1b'-Cnb') comprend une ou plusieurs couches d'un film mince, d'un film épais ou de cristaux d'un terpolymère ou d'un matériau céramique ferroélectrique.

14. Procédé selon les revendications 11 à 12, dans lequel la production et le transfert d'une énergie de refroidissement comprennent le refroidissement d'un corps solide, d'un fluide ou d'une combinaison de ceux-ci, et dans lequel le diélectrique de matériau électrocalorique desdits condensateurs (C1, C1', C2, C2', C3, C1a-Cna, C1b-Cnb, C1a'-Cna', C1b'-Cnb') comprend une ou plusieurs couches d'un film mince, d'un film épais ou de cristaux d'un matériau céramique ferroélectrique.

15. Procédé selon la revendication 11, dans lequel ladite fréquence de résonance $f_r$ est supérieure ou égale à 2 kHz.

16. Appareil de chauffage ou de refroidissement comprenant un dispositif de production et de transfert d'une énergie de chauffage et de refroidissement selon l'une quelconque des revendications 1 à 10.

# Fig. 1

V1

L1

C1

M1

V2

# Fig. 2

# Fig. 3

V1

L1

C1

C1'

L1'

M1

V2

# Fig. 4

L1          L1'

V1

C1

M1

V2

# Fig. 5

L1        L2

V1

C1        C2

M1

V2

Fig. 6

L1                            L2

V1

C1

M1

V2

C2

# Fig. 7

Fig. 8

Fig. 9

Fig. 10

Fig. 11

Fig. 12

Fig. 13

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6877325 B
- US 8371128 B

- US 5644184 A
- WO 2013167176 A

**Non-patent literature cited in the description**

- **GAEL SEBALD ; LAURENCE SEVEYRAT ; JEAN-FABIEN CAPSAL ; PIERRE-JEAN COTTINET ; DANIEL GUYOMAR.** *APPLIED PHYSICS LETTERS,* vol. 101, 022907-2012